# FASCICULE DE BREVET EUROPEEN

(11) **EP 3 093 936 B1**
(45) Date de publication et mention de la délivrance du brevet: **24.01.2018**
(21) Numéro de dépôt: 16161046.4
(22) Date de dépôt: 18.03.2016
(51) Int. Cl.: H02B 1/56, H02B 1/052, H05K 7/20

(54) **SYSTÈME DE DISSIPATION THERMIQUE POUR ENVELOPPE ÉLECTRIQUE**
WÄRMEABLEITUNGSSYSTEM FÜR ELEKTROHÜLLE
THERMAL DISSIPATION SYSTEM FOR AN ELECTRICAL ENCLOSURE

(30) Priorité: 11.05.2015 FR 1554197
(43) Date de publication de la demande: 16.11.2016
(73) Titulaire: Schneider Electric Industries SAS, 92500 Rueil-Malmaison (FR)
(72) Inventeur: LOPEZ, Josep, 38050 GRENOBLE (FR); PERRIN, Alain, 38050 GRENOBLE (FR)

(56) Documents cités:
- EP-A1- 2 190 277
- FR-A1- 3 010 846
- US-A1- 2010 134 972
- US-A1- 2015 003 010

## Description

### Domaine technique de l'invention

La présente invention se rapporte à un système de dissipation thermique destiné à réguler la température à l'intérieur d'une enveloppe électrique.

L'invention a également pour objet une enveloppe électrique renfermant au moins un appareil électrique à réguler thermiquement et comprenant au moins un tel système de dissipation thermique.

### Etat de la technique

Actuellement, les enveloppes électriques intègrent des appareils électriques ou électroniques qui dissipent de la chaleur sous forme de calories. Cette chaleur dégagée au sein des enveloppes doit être évacuée pour garantir le bon fonctionnement des systèmes électriques. Les enveloppes comprennent dès lors un système de dissipation thermique pour amener du gaz de refroidissement dans l'enveloppe et pour l'évacuer hors de l'enveloppe. Le système de dissipation thermique est généralement constitué par un simple ventilateur ou par une climatisation comprenant un échangeur et un condenseur. Dans les deux cas, un ventilateur de type axial ou radial assure une circulation du gaz. La demande de brevet FR3010846A1 décrit une solution de refroidissement comportant notamment un conduit dans lequel circule un gaz de refroidissement et dont la position est réglable pour déboucher au plus près des appareils électriques à refroidir.

Ces solutions ne sont pas satisfaisantes car elles ne permettent pas de refroidir efficacement tous les appareils électriques, notamment lorsque ceux-ci sont nombreux à l'intérieur de l'enveloppe électrique.

Des solutions de refroidissement ont notamment été décrites dans les demandes de brevet US2015/003010 et EP2190277A1. Dans la demande US2015/003010, il s'agit juste d'évacuer l'air chaud généré par des serveurs en fonctionnement en contrôlant notamment un ventilateur asservi par une différence de pression. Dans la demande de brevet EP2190277A1, il s'agit d'employer un régulateur de température qui injecte un liquide réfrigérant dans un circuit de refroidissement formé d'un conduit, comme défini par le préambule de la revendication 1. Le but de l'invention est donc de proposer un système de dissipation thermique destiné à refroidir de manière efficace les appareils électriques placés à l'intérieur d'une enveloppe électrique.

Ce but est atteint par un système de dissipation thermique défini dans la revendication 1.

Selon une particularité, le système comporte des moyens de réglage du débit d'air dans le conduit, lesdits moyens de réglage étant commandés par le contrôleur logique programmable en fonction d'une température présente dans l'enveloppe électrique.

Selon une autre particularité, le conduit comporte des orifices pour diffuser le gaz de refroidissement dans le volume de l'enveloppe.

Selon une autre particularité, le conduit comporte une surface interne comprenant des ailettes de refroidissement.

Selon une autre particularité, le dispositif de ventilation comporte au moins un ventilateur.

Selon une autre particularité, le système comporte un climatiseur agencé pour refroidir le gaz de refroidissement.

Selon une autre particularité, la chambre de distribution est réalisée sur la paroi latérale de l'enveloppe.

Selon une autre particularité, le système comporte une chambre de circulation réalisée sur la paroi latérale de l'enveloppe et agencée pour être en communication avec le volume de l'enveloppe pour permettre une circulation du gaz de refroidissement sur la longueur de l'enveloppe.

Selon une autre particularité, le conduit comporte un support pour fixer un ou plusieurs appareils électriques.

Selon une autre particularité, le support comporte un rail DIN.

### Brève description des figures

D'autres caractéristiques et avantages vont apparaître dans la description détaillée qui suit faite en regard des dessins annexés dans lesquels :
- les figures 1A et 1B représentent, de manière schématique, respectivement en vue de face et de côté, l'architecture d'une enveloppe électrique,
- la figure 2 représente, de manière schématique, en vue de face, l'architecture d'une enveloppe électrique incluant le système de dissipation thermique de l'invention,
- les figures 3A à 3C représentent des variantes de réalisation et d'agencement des conduits employés dans le système de dissipation thermique de l'invention,
- la figure 4 représente, de manière schématique, en vue de face, l'architecture d'une enveloppe électrique incluant le système de dissipation thermique de l'invention, réalisé selon un mode de réalisation particulier,
- la figure 5 représente, de manière schématique, l'architecture d'une enveloppe électrique incluant le système de dissipation thermique de l'invention, réalisé selon un autre mode de réalisation particulier,
- la figure 6 représente, de manière schématique, l'architecture d'une enveloppe électrique incluant le système de dissipation thermique de l'invention, réalisé selon un autre mode de réalisation particulier.

### Description détaillée d'au moins un mode de réalisation

L'invention concerne un système de dissipation thermique destiné à être installé dans une enveloppe électrique, telle que par exemple une armoire ou un coffret électrique.

L'enveloppe électrique 1 est fermée et définit un volume 10 interne à l'intérieur duquel sont placés un ou plusieurs appareils électriques 2 ou électroniques. Par appareil électrique 2 ou électronique, on entend par exemple des disjoncteurs, contacteurs, variateurs de vitesse, automates programmables,... Dans la suite de la description, nous utiliserons le terme appareil électrique 2 pour désigner tous ces appareils.

L'enveloppe électrique 1 est par exemple de forme parallélépipédique avec une paroi supérieure 11, une paroi inférieure 12 et quatre parois latérales 13, l'une des parois latérales formant la porte de l'enveloppe. Pour la suite de la description, nous définissons un axe principal (X) s'étendant perpendiculairement aux parois supérieure et inférieure de l'enveloppe électrique 1 et parallèlement aux parois latérales 13.

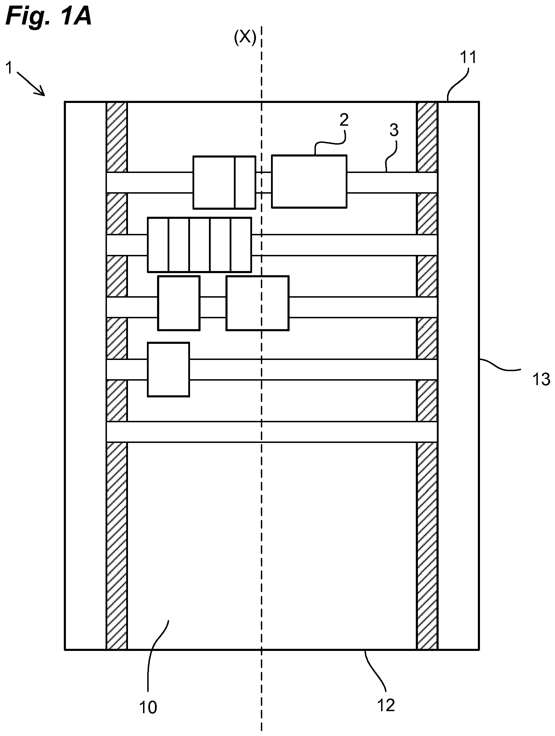

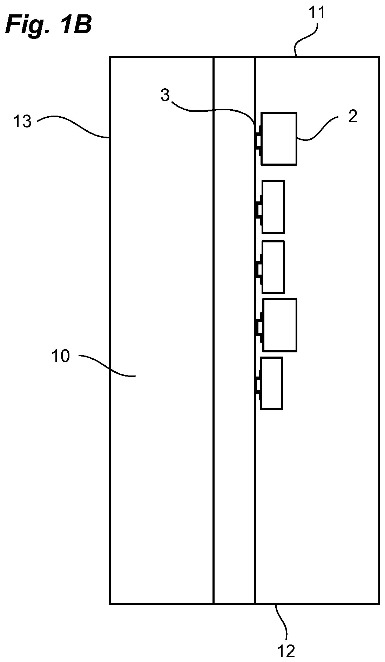

De manière connue, en référence aux figures 1A et 1B, une enveloppe électrique comporte généralement plusieurs supports 3 pour supporter les appareils électriques 2. Ces supports comportent par exemple des traverses s'étendant de manière transversale entre les deux montants. Chaque traverse comporte par exemple un rail DIN sur lequel vient s'accrocher au moins un appareil électrique. De manière connue, un rail DIN présente une section transversale en forme de chapeau avec une partie centrale et deux ailes s'étendant vers l'extérieur. Les supports peuvent être agencés dans un plan médian vertical à l'intérieur de l'enveloppe (comme sur la figure 1B) ou être disposés dans le fond de celle-ci, contre une paroi latérale, opposée à celle formant la porte de l'enveloppe.

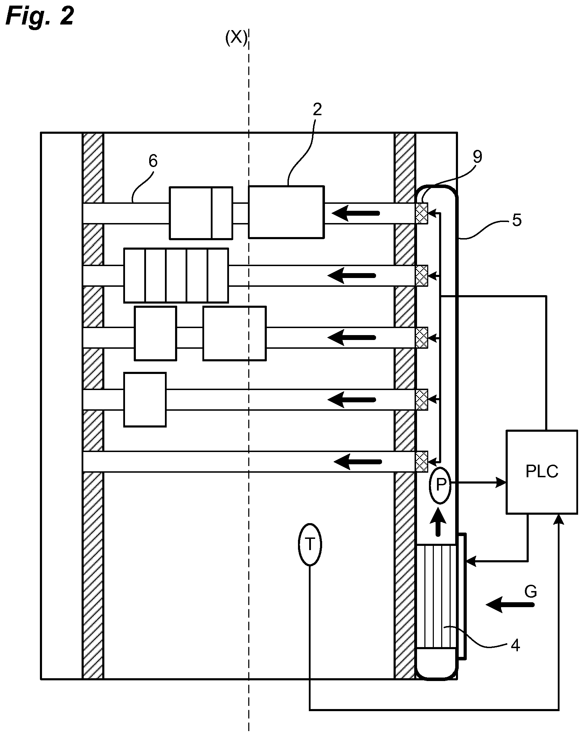

En référence à la figure 2, le système de dissipation thermique de l'invention comporte au moins un dispositif de ventilation 4 permettant une circulation d'un gaz de refroidissement G nécessaire pour refroidir les appareils électriques 2. Ce dispositif de ventilation 4 comporte par exemple au moins un ventilateur. Chaque dispositif de ventilation 4 peut être agencé pour aspirer le gaz de refroidissement et l'injecter à l'intérieur du système de dissipation et/ou pour faire circuler le gaz de refroidissement G dans le système de dissipation. Le gaz de refroidissement G est par exemple de l'air.

Selon l'invention, le système de dissipation thermique comporte également au moins une chambre de distribution 5 communiquant avec le dispositif de ventilation 4 et dans laquelle le gaz de refroidissement G est injecté et mis en pression par le dispositif de ventilation. Préférentiellement, la chambre de distribution 5 s'étend sur une majeure partie de la hauteur de l'enveloppe électrique 1 suivant l'axe principal (X). Selon l'invention, le gaz de refroidissement G est mis en pression dans la chambre de distribution 5. Le dispositif de ventilation est asservi en fonction de la pression du gaz de refroidissement G régnant dans la chambre de distribution. Préférentiellement, cette chambre de distribution est située à l'extérieur du volume 10 formé par l'enveloppe.

Selon l'invention, le système de dissipation thermique de l'invention comporte également un ou plusieurs conduits 6 comportant chacun une première extrémité en communication avec la chambre de distribution 5 et une deuxième extrémité en communication avec une autre chambre de distribution ou avec une chambre de circulation, également située à l'extérieur du volume interne formé par l'enveloppe. Chaque conduit 6 s'étend dans le volume de l'enveloppe suivant une direction transversale par rapport à l'axe principal (X). Chaque conduit traverse ainsi le volume 10 interne formé par l'enveloppe, préférentiellement d'une paroi latérale de l'enveloppe à la paroi latérale opposée. Les conduits sont par exemple agencés en parallèle entre les deux parois latérales.

Avantageusement, le système peut comporter des moyens de réglage 9 du débit du gaz de refroidissement à l'intérieur des conduits. Ces moyens de réglage 9 sont par exemple auto-régulés ou commandés en fonction d'une température mesurée ou estimée à l'intérieur du volume de l'enveloppe électrique. Il peut s'agir par exemple d'électrovannes à débit variable. Ils sont par exemple positionnés à une ou aux deux extrémités des conduits.

Avantageusement, le système de dissipation de l'invention peut comporter au moins un climatiseur 7 en communication avec le dispositif de ventilation de manière à refroidir le gaz de refroidissement mis en mouvement par le dispositif de ventilation. Un circuit est agencé dans l'armoire électrique pour aspirer les gaz chauds présents dans l'enveloppe électrique grâce au dispositif de ventilation, les injecter dans le climatiseur 7 pour être refroidis et amenés dans la chambre de distribution 5 ou dans le volume 10 de l'enveloppe.

Avantageusement, le système de dissipation de l'invention peut également comporter une chambre de circulation 8 dans laquelle débouchent les conduits 6 et destinée à permettre une évacuation du gaz de refroidissement G. Le gaz de refroidissement est avantageusement aspiré dans la chambre de circulation 8 par un deuxième dispositif de ventilation 40. Cette chambre de circulation 7 a par exemple la forme d'une cheminée dans laquelle débouchent les conduits et qui s'étend le long de l'axe principal, le long d'une paroi latérale opposée à celle accueillant la chambre de distribution.

Selon l'invention, le système comporte un contrôleur logique programmable (PLC) pour assurer le fonctionnement du système. Il comporte au moins un module d'entrée connecté à un capteur de pression (P) présent dans la chambre de distribution 5 et recevant les données de pression mesurées par ce capteur et au moins un module de sortie connecté au dispositif de ventilation 4 et agencé pour envoyer des ordres de commande au dispositif de ventilation 4 pour commander sa vitesse en fonction de la pression mesurée dans la chambre de distribution 5 et d'une pression de consigne souhaitée dans ladite chambre. Avantageusement, il comporte également au moins un module d'entrée connecté à un capteur de température (T) présent dans l'enveloppe électrique 1 pour recevoir des données de la température présente dans l'enveloppe électrique et au moins un module de sortie agencé pour commander le climatiseur 7 en fonction de la température mesurée et d'une température de consigne. Le contrôleur comporte également un ou plusieurs modules de sortie agencés chacun pour commander les moyens de réglage du débit d'air dans chaque conduit. Il pourra s'agir d'une commande individualisée du débit d'air dans chaque conduit ou d'une commande globale de sorte que le débit sera identique dans tous les conduits. Les moyens de réglage 9 du débit d'air sont commandés en fonction de la température mesurée dans l'enveloppe électrique 1 par le capteur de température (T) et d'une température de consigne.

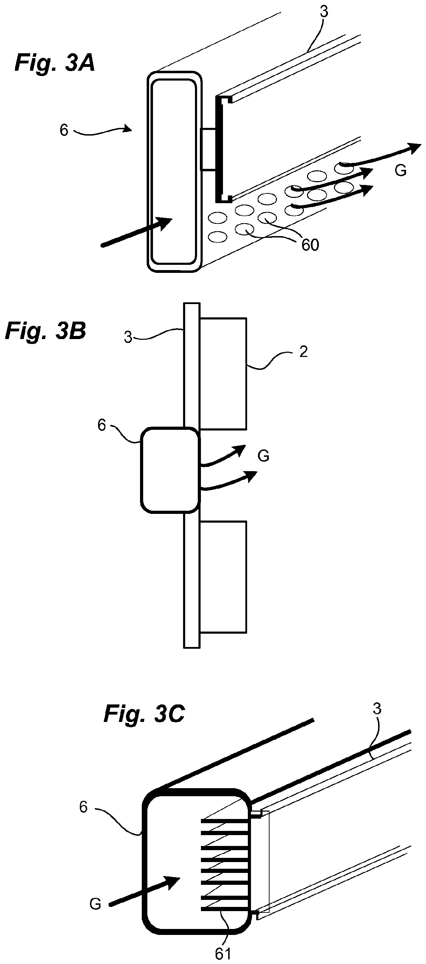

Dans une première variante de réalisation représentée sur les figures 3A et 3B, chaque conduit comporte plusieurs orifices 60 répartis sur toute sa longueur et destinés à diffuser le gaz de refroidissement dans le volume défini par l'enveloppe. Sur la figure 3A, le support 3 d'appareils électriques, par exemple un rail DIN, est fixé directement sur le conduit 6 de sorte que le gaz de refroidissement qui débouche par les orifices 60 réalisés à travers le conduit vient directement en contact avec les appareils électriques attachés au support. Sur la figure 3B, un conduit est agencé entre deux rangées d'appareils électriques fixés sur des rails DIN ou sur d'autres types de supports adaptés.

Dans une deuxième variante de réalisation représentée sur la figure 3C, chaque conduit 6 a la forme d'un tube ouvert à ses deux extrémités et comporte avantageusement une paroi ayant une face interne et une face externe. Sur sa face interne, la paroi du conduit comporte des ailettes de refroidissement 61 agencées pour refroidir les appareils électrique par convection. Sur sa face externe, la paroi du conduit comporte un support 3 de fixation des appareils électriques, par exemple un rail DIN. Grâce à cet agencement, les appareils électriques sont refroidis par convection grâce au gaz de refroidissement G diffusé dans le conduit, entre les ailettes de refroidissement.

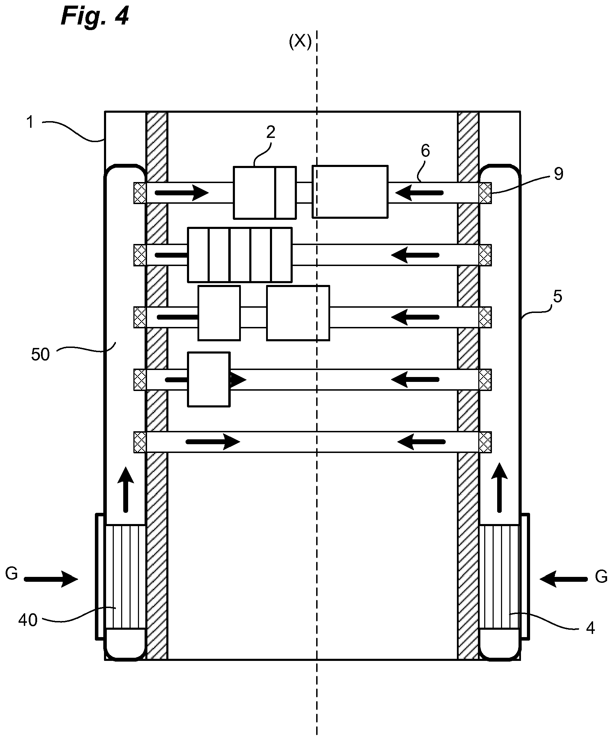

En référence aux figures 4 à 6 et à partir des composants décrits ci-dessus, le système de dissipation thermique de l'invention peut se décliner en plusieurs architectures distinctes :
- sur la figure 4, le système de dissipation thermique comporte deux dispositifs de ventilation 4, 40 qui aspirent le gaz de refroidissement G situé à l'extérieur de l'enveloppe 1 et deux chambres de distribution 5, 50 communiquant chacune avec un dispositif de ventilation 4, 40 distinct pour recevoir le gaz de refroidissement G aspiré. Les deux chambres de distribution 5, 50 sont agencées verticalement, le long de deux parois latérales opposées de l'enveloppe 1. Plusieurs conduits 6 sont agencés transversalement entre les deux chambres de distribution 5, 50. Le gaz de refroidissement mis sous pression dans chaque chambre de distribution est injecté dans les conduits 6 par commande des moyens de réglage 9 de débit du gaz de refroidissement situés aux deux extrémités des conduits. Les conduits sont munis de plusieurs orifices 60 répartis sur leur longueur pour diffuser le gaz de refroidissement G dans le volume défini par l'enveloppe. Une bouche d'aération, non visible sur la figure, est par exemple agencée pour évacuer le gaz de refroidissement à l'extérieur de l'enveloppe. Sur la figure 4, pour simplifier, nous n'avons pas représenté le contrôleur logique programmable (PLC). Ce type d'architecture à deux entrées de gaz sera particulièrement adapté pour les armoires de grande largeur.

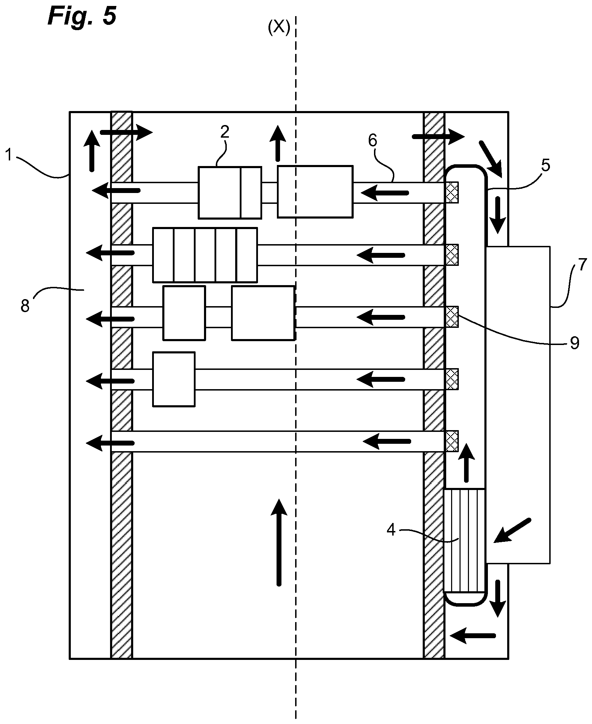

- Sur la figure 5, le système de dissipation thermique fonctionne en circuit fermé. Il comporte un climatiseur 7 chargé de refroidir le gaz de refroidissement G présent dans l'enveloppe électrique 1, un dispositif de ventilation 4 chargé de faire circuler le gaz de refroidissement dans le système, une chambre de distribution 5 dans laquelle le dispositif de ventilation injecte le gaz de refroidissement obtenu en sortie du climatiseur et une chambre de circulation 8 agencée pour recueillir le gaz de refroidissement G en sortie des conduits pour les ramener vers le climatiseur. Plusieurs conduits 6 sont agencés entre la chambre de distribution 5 et la chambre de circulation 8. Le gaz de refroidissement refroidi par le climatiseur est injecté dans la chambre de distribution 5. Le gaz de refroidissement est injecté dans les conduits à partir de la chambre de distribution par commande des moyens de réglage 9 du débit. Une partie du gaz de refroidissement obtenue en sortie du climatiseur est également injectée directement dans le volume de l'enveloppe. Chaque conduit 6 comporte par exemple des ailettes de refroidissement 61 de manière à refroidir les appareils électriques 2 par convection. Pour des raisons de simplification, le contrôleur logique programmable PLC n'a pas été représenté sur la figure 5.

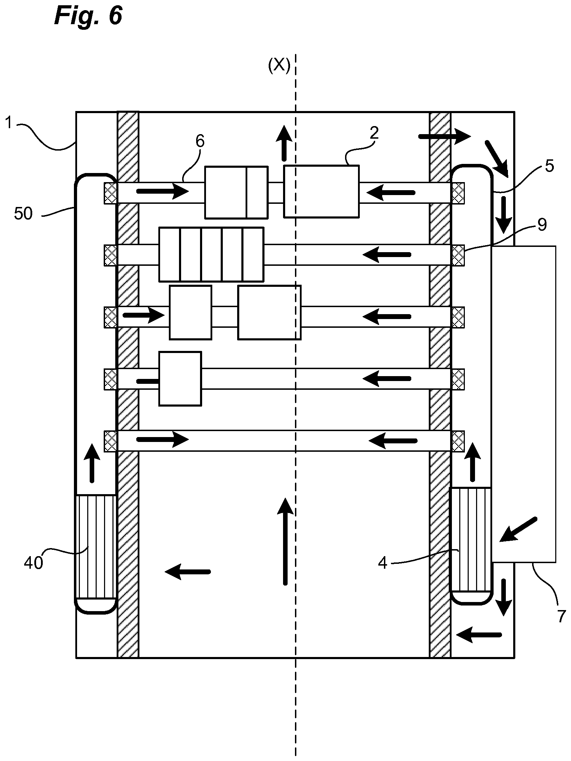

- Sur la figure 6, le système de dissipation thermique fonctionne en circuit fermé. Il comporte un climatiseur 7 chargé de refroidir le gaz de refroidissement G présent dans l'enveloppe, un premier dispositif de ventilation 4 chargé de faire circuler le gaz de refroidissement dans le système, une première chambre de distribution 5 dans laquelle le premier dispositif de ventilation 4 injecte le gaz de refroidissement obtenu en sortie du climatiseur 7, une deuxième chambre de distribution 50 et un deuxième dispositif de ventilation 40 agencé pour aspirer le gaz de refroidissement G présent dans l'enveloppe 1 pour l'injecter dans la deuxième chambre de distribution 50. Plusieurs conduits 6 sont agencés entre les deux chambres de distribution 5, 50. Le gaz de refroidissement G est injecté dans les conduits 6 à partir des chambres de distribution en commandant les moyens de réglage 9 du débit. Une partie du gaz de refroidissement obtenu en sortie du climatiseur est également injectée directement dans le volume 10 de l'enveloppe et peut être aspirée par le deuxième dispositif de ventilation 40 et injectée dans la deuxième chambre de distribution 50. Le gaz de refroidissement est injecté dans chaque conduit à partir des deux chambres de distribution 5, 50. Chaque conduit 6 comporte par exemple des orifices répartis sur sa longueur et destinés à diffuser le gaz de refroidissement dans le volume de l'enveloppe. Pour des raisons de simplification, le contrôleur logique programmable PLC n'a pas été représenté sur la figure 6.

## Revendications

1. Système de dissipation thermique destiné à réguler la température d'un appareil électrique (2) placé dans un volume délimité par une enveloppe électrique (1) et comprenant :
- un dispositif de ventilation (4) d'un gaz de refroidissement (G) destiné à faire circuler un gaz de refroidissement,
- une chambre de distribution (5) en communication avec le dispositif de ventilation et dans laquelle le gaz de refroidissement est mis en pression par le dispositif de ventilation (4),
- au moins un conduit agencé dans le volume de l'enveloppe électrique (1), en communication avec la chambre de distribution (5) pour recevoir le gaz de refroidissement (G) en provenance de ladite chambre,
- **caractérisé en ce que** chaque conduit comportant une première extrémité en communication avec la chambre de distribution (5) et une deuxième extrémité en communication avec une autre chambre de distribution ou avec une chambre de circulation,
et **en ce que** le système de dissipation thermique comporte
- un contrôleur logique programmable (PLC) agencé pour commander dispositif de ventilation (4) en vue d'obtenir une pression déterminée dans ladite chambre de distribution (5).

2. Système selon la revendication 1, **caractérisé en ce qu'**il comporte des moyens de réglage (9) du débit d'air dans le conduit (6), lesdits moyens de réglage (9) étant commandés par le contrôleur logique programmable (PLC) en fonction d'une température présente dans l'enveloppe électrique (1).

3. Système selon la revendication 1, **caractérisé en ce que** le conduit (6) comporte des orifices (60) pour diffuser le gaz de refroidissement (G) dans le volume de l'enveloppe.

4. Système selon la revendication 1, **caractérisé en ce que** le conduit (6) comporte une surface interne comprenant des ailettes de refroidissement (61).

5. Système selon l'une des revendications 1 à 3, **caractérisé en ce que** le dispositif de ventilation (4) comporte au moins un ventilateur.

6. Système selon l'une des revendications 1 à 4, **caractérisé en ce qu'**il comporte un climatiseur (7) agencé pour refroidir le gaz de refroidissement.

7. Système selon l'une des revendications 1 à 5, **caractérisé en ce que** la chambre de distribution (5) est réalisée sur la paroi latérale de l'enveloppe.

8. Système selon l'une des revendications 1 à 7, **caractérisé en ce qu'**il comporte une chambre de circulation (6) réalisée sur la paroi latérale de l'enveloppe et agencée pour être en communication avec le volume de l'enveloppe pour permettre une circulation du gaz de refroidissement sur la longueur de l'enveloppe.

9. Système selon l'une des revendications 1 à 7, **caractérisé en ce que** le conduit (6) comporte un support (3) pour fixer un ou plusieurs appareils électriques (2).

10. Système selon la revendication 8, **caractérisé en ce que** le support comporte un rail DIN.

## Patentansprüche

1. Wärmeableitungssystem, das dazu bestimmt ist, die Temperatur eines elektrischen Geräts (2) zu regeln, das in einem von einem elektrischen Gehäuse (1) begrenzten Volumen angeordnet ist, und enthält:
- eine Ventiliervorrichtung (4) eines Kühlgases (G), die dazu bestimmt ist, ein Kühlgas zirkulieren zu lassen,
- eine Verteilungskammer (5) in Verbindung mit der Ventiliervorrichtung und in der das Kühlgas von der Ventiliervorrichtung (4) unter Druck gesetzt wird,
- mindestens einen Kanal, der im Volumen des elektrischen Gehäuses (1) angeordnet ist, in Verbindung mit der Verteilungskammer (5), um das von der Kammer kommende Kühlgas (G) zu empfangen,
**dadurch gekennzeichnet, dass** jeder Kanal ein erstes Ende in Verbindung mit der Verteilungskammer (5) und ein zweites Ende in Verbindung mit einer anderen Verteilungskammer oder mit einer Zirkulationskammer aufweist,
und dass das Wärmeableitungssystem
- eine speicherprogrammierbaren Steuerung (PLC) aufweist, die eingerichtet ist, die Ventiliervorrichtung (4) zu steuern, um einen bestimmten Druck in der Verteilungskammer (5) zu erhalten.

2. System nach Anspruch 1, **dadurch gekennzeichnet, dass** es Regelungseinrichtungen (9) des Luftdurchsatzes im Kanal (6) aufweist, wobei die Regelungseinrichtungen (9) vom der speicherprogrammierbaren Steuerung (PLC) abhängig von einer im elektrischen Gehäuse (1) vorhandenen Temperatur gesteuert werden.

3. System nach Anspruch 1, **dadurch gekennzeichnet, dass** der Kanal (6) Öffnungen (60) aufweist, um das Kühlgas (G) im Volumen des Gehäuses zu verteilen.

4. System nach Anspruch 1, **dadurch gekennzeichnet, dass** der Kanal (6) eine Innenfläche aufweist, die Kühlrippen (61) enthält.

5. System nach einem der Ansprüche 1 bis 3, **dadurch gekennzeichnet, dass** die Ventiliervorrichtung (4) mindestens einen Ventilator aufweist.

6. System nach einem der Ansprüche 1 bis 4, **dadurch gekennzeichnet, dass** es ein Klimagerät (7) aufweist, das eingerichtet ist, um das Kühlgas zu kühlen.

7. System nach einem der Ansprüche 1 bis 5, **dadurch gekennzeichnet, dass** die Verteilungskammer (5) auf der Seitenwand des Gehäuses hergestellt ist.

8. System nach einem der Ansprüche 1 bis 7, **dadurch gekennzeichnet, dass** es eine Zirkulationskammer (6) aufweist, die auf der Seitenwand des Gehäuses hergestellt und eingerichtet ist, um mit dem Volumen des Gehäuses in Verbindung zu stehen, um eine Zirkulation des Kühlgases über die Länge des Gehäuses zu ermöglichen.

9. System nach einem der Ansprüche 1 bis 7, **dadurch gekennzeichnet, dass** der Kanal (6) einen Träger (3) aufweist, um eines oder mehrere elektrische Geräte (2) zu befestigen.

10. System nach Anspruch 8, **dadurch gekennzeichnet, dass** der Träger eine DIN-Schiene aufweist.

## Claims

1. Heat dissipation system intended to regulate the temperature of an electrical unit (2) positioned within a volume delineated by an electrical enclosure (1) and comprising:
- a cooling gas (G) ventilation device (4) intended to circulate a cooling gas,
- a distribution chamber (5) in communication with the ventilation device and in which the cooling gas is pressurized by the ventilation device (4),
- at least one duct arranged within the volume of the electrical enclosure (1), in communication with the distribution chamber (5) in order to receive the cooling gas (G) originating from said chamber,
**characterized in that** each duct has a first end in communication with the distribution chamber (5) and a second end in communication with another distribution chamber or with a circulation chamber,
and **in that** the heat dissipation system includes
- a programmable logic controller (PLC) designed to control the ventilation device (4) for the purpose of obtaining a determined pressure in said distribution chamber (5).

2. System according to Claim 1, **characterized in that** it includes means (9) for regulating the flow of air in the duct (6), said regulating means (9) being controlled by the programmable logic controller (PLC) depending on a temperature present in the electrical enclosure (1).

3. System according to Claim 1, **characterized in that** the duct (6) has orifices (60) for diffusing the cooling gas (G) into the volume of the enclosure.

4. System according to Claim 1, **characterized in that** the duct (6) has an internal surface comprising cooling fins (61).

5. System according to one of Claims 1 to 3, **characterized in that** the ventilation device (4) includes at least one fan.

6. System according to one of Claims 1 to 4, **characterized in that** it includes an air conditioner (7) designed to cool the cooling gas.

7. System according to one of Claims 1 to 5, **characterized in that** the distribution chamber (5) is produced on the lateral wall of the enclosure.

8. System according to one of Claims 1 to 7, **characterized in that** it includes a circulation chamber (6) produced on the lateral wall of the enclosure and designed to be in communication with the volume of the enclosure so as to enable the cooling gas to circulate over the length of the enclosure.

9. System according to one of Claims 1 to 7, **characterized in that** the duct (6) has a support (3) for fastening one or more electrical units (2).

10. System according to Claim 8, **characterized in that** the support includes a DIN rail.
